(19) Europäisches Patentamt
European Patent Office
Office européen des brevets

(11) **EP 2 461 174 A1**

(12) **EUROPEAN PATENT APPLICATION**
published in accordance with Art. 153(4) EPC

(43) Date of publication:
**06.06.2012 Bulletin 2012/23**

(51) Int Cl.:
**G01R 33/09** (2006.01)    **G01R 21/08** (2006.01)
**H01L 43/08** (2006.01)

(21) Application number: **10811972.8**

(22) Date of filing: **26.08.2010**

(86) International application number:
**PCT/JP2010/064532**

(87) International publication number:
**WO 2011/024923 (03.03.2011 Gazette 2011/09)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority:   **26.08.2009   JP 2009195103**
                 **26.08.2009   JP 2009195104**

(71) Applicant: **Panasonic Corporation**
**Kadoma-shi**
**Osaka 571-8501 (JP)**

(72) Inventors:
• **TAKENAGA, Hideki**
  **Osaka-shi, Osaka 540-6207 (JP)**
• **IWAMI, Eiji**
  **Osaka-shi, Osaka 540-6207 (JP)**
• **SAWADA, Tomoyuki**
  **Osaka-shi, Osaka 540-6207 (JP)**
• **TSUJIMOTO, Hiroaki**
  **Osaka-shi, Osaka 558-8585 (JP)**
• **YOSHIKAWA, Keisuke**
  **Osaka-shi, Osaka 540-6207 (JP)**
• **FUKUI, Suguru**
  **Osaka-shi, Osaka 540-6207 (JP)**

(74) Representative: **Müller-Boré & Partner**
**Patentanwälte**
**Grafinger Straße 2**
**81671 München (DE)**

(54) **MAGNETIC FIELD SENSOR, AS WELL AS MAGNETIC FIELD MEASUREMENT METHOD, POWER MEASUREMENT DEVICE, AND POWER MEASUREMENT METHOD USING THE SAME**

(57)    Positive and negative directions can be determined, and a magnetic field can be detected with high reliability.

A magnetic field sensor according to the present invention includes a ferromagnetic thin film 3, feeders 5A and 5B having input and output terminals configured to supply element current to the ferromagnetic thin film, and detectors 5C, 5D configured to detect voltage across the ferromagnetic thin film (between ends thereof) in a direction perpendicular to a direction of the element current, in which the ferromagnetic thin film is formed to be symmetric about the direction of the element current.

FIG. 2

$$V_{CD} = I_2 \Delta R \sin 2\theta$$

EP 2 461 174 A1

**Description**

**Technical Field**

The present invention relates to a magnetic field sensor, a magnetic field measurement method using the magnetic field sensor, a power measurement device, and a power measurement method, and more particularly to a power measurement device that extracts a voltage of a magnetic field sensor for realizing a magnetic field measurement with high precision, and using the magnetic field sensor.

**Background Art**

In recent years, the development of a measurement system including remote power meter reading has been forwarded in environment where the Internet is available..

There is used a power meter using a method in which a sensor that detects rotation is added, or an ammeter (CT) and a voltmeter (PT) are newly added to an existing integrating power meter that converts a used electric power into the number of rotations of a disc, and conducts integration operation, and multiplicative computation is conducted by an electric circuit or a microprocessor to measure the electric power. However, the power meter of this type is not only upsized in device, but also expensive, and would also consume an unnecessary energy.

Under the circumstances, there has been desired the development of the power meter which can measure a power consumption as the quality of electricity as it is, and can be also downsized and integrated.

In particular, there has been proposed a power measurement device that can measure the power consumption as the quantity of electricity as it is, by the aid of a magnetoresistive effect of a magnetic thin film (Non Patent Documents 1 and 2).

This power measurement device is configured so that a magnetic thin film that is put in parallel to a primary conductor into which AC current flows (configured on a substrate) is used, a primary voltage is applied to both ends of the magnetic thin film through a resistor, and an output is extracted from (both ends) of the magnetic thin film. The power measurement device is of a system in which an electric power IV is extracted from an amplitude value of a second harmonic component.

In the power measurement device, a signal component proportional to the electric power is extracted, paying attention to a fact that a linear characteristic can be obtained with no bias magnetic field by the aid of a planar hall effect that is a phenomenon in which a resistance value of a magnetic material is changed according to an angle formed between current and magnetization.

The magnetic field sensor used in this device is an element that converts a change in external magnetic field into an electric signal, which patterns a magnetic thin film such as a ferromagnetic thin film or a semiconductor thin film, and allows current to flow in a pattern of the magnetic thin film to convert the change in the external magnetic field into an electric signal as a voltage change.

In this example, an output signal is represented as the following Expression (1).

(Math. 1)

$$V_{mr} = \frac{\overbrace{\dfrac{R1 \cdot R3 - R2 \cdot R4}{R1 + R2 + R3 + R4} \cdot \sqrt{2} I_2 \cos \omega t}^{(A1)}}{\omega}$$

$$+ \underbrace{\frac{\overbrace{\dfrac{k \cdot R3}{R1 + R2 + R3 + R4} \cdot I_1 \cdot V_1 \cos \theta}^{} + \dfrac{\overbrace{\dfrac{k \cdot R3}{R1 + R2 + R3 + R4} \cdot I_1 \cdot V_1 \cos(2\omega t + \theta)}^{(A2)}}{2\omega}}_{DC}}{}$$

$$+ \text{harmonic component}$$

$$P = I \cdot V \cdot \cos \theta$$

(1)

In this expression, the output is divided into a term of a DC component and a term of an AC component. A1 is an unnecessary term irrelevant to an electric power developed by unbalance of bridge resistors, and A2 is a term (instantaneous electric power) proportional to the electric power.

A variety of proposals have been made to enhance the sensitivity of the magnetic field sensor. For example, Patent Document 1 has also proposed a magnetic field sensor in which a part of an annular pattern is opened to form a current carrying part for designing the high sensitivity.

**Related Art Documents**

**Patent Documents**

Patent Document 1: JP-A-11-274598

**Non-Patent Documents**

Non Patent Document 1: Thin Film Power Meter using Magnetic Film (Institute of Electrical Engineers, Magnetic Association Document VOL. MAG-05 No. 182)
Non Patent Document 2: Thin Film Power Meter using Magnetic Film (Institute of Electrical Engineers, Magnetic Association Document VOL. MAG-05 No. 192)

**Summary of the Invention**

**Problem to be Solved by the Invention**

However, the above power measurement device employs a method in which along with measurement of a value of an amplitude value $I_1 \cdot V_1$ of a $2\omega$ component, a power factor $\cos\theta$ is measured, separately, and multiplication is conducted, separately, to obtain $I_1 \cdot V_1 \cdot \cos\theta$. If the power factor is not 1, there is a need to measure and compute the power factor, separately. Also, in the case of a current waveform having a harmonic component, there arises such a problem that nothing other than an electric power of a fundamental component can be extracted.

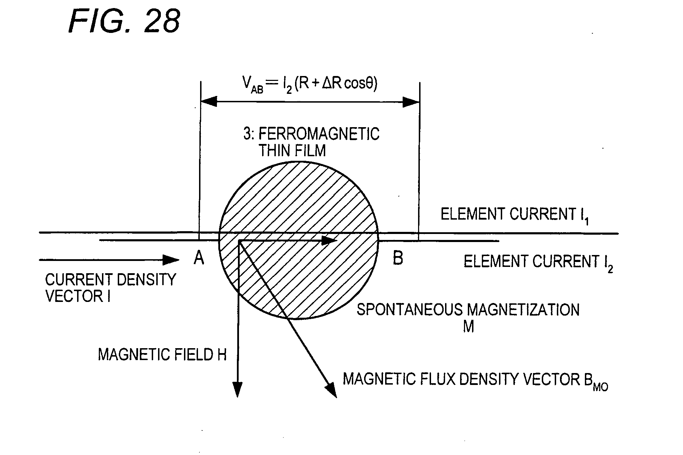

Also, the magnetic sensor suffers from the following problems. For example, as illustrated in FIG. 28, it is assumed that current $I_1$ flows in a conductor 200 arranged on a magnetic thin film 100 having a ferromagnetic characteristic along a diametrical direction thereof, a magnetic field developed by the current is H, and spontaneous magnetization of the element is M. In this case, when it is assumed that a magnetic flux density vector in which the external magnetic field vector H and the spontaneous magnetization vector M of the element are combined together is $B_{MO}$, an angle formed between a current density vector I and the magnetic flux density vector $B_{MO}$ is $\theta$, a resistor between points A and B of the magnetic thin film 100 is R, and a maximum of a resistance value between the points A and B which is changed according to a magnetic field is $\Delta R$, a voltage $V_{AB}$ between the points A and B is represented as follows:

$$V_{AB} = I_2(R + \Delta R \cos 2\theta) \qquad \dots (2)$$

where $I_2$ is element current.

However, the above configuration suffers from such a problem that positive and negative directions cannot be discriminated when applying an AC magnetic field. This is because $\cos 2\theta$ has the same value in positive and negative in the above Expression (2).

The present invention has been made in view of the above circumstances, and an object of the present invention is to provide a magnetic field sensor that can determine the positive and negative directions, and detect the magnetic field with high reliability.

Another object of the present invention is to provide a power measurement device that can easily measure an electric power without separate measurement of a power factor.

**Means for Solving the Problem**

Under the circumstances, according to the present invention, there is provided a magnetic field sensor including a magnetic thin film, a feeder having an input and output terminal that supplies element current to the magnetic thin film, and a detector that detects a voltage between ends of the magnetic thin film in a direction perpendicular to a direction of the element current, in which the magnetic thin film is symmetric about the direction of the element current.

Also, according to the present invention, in the magnetic field sensor, the magnetic thin film has a circular contour.

Also, according to the present invention, in the magnetic field sensor, the magnetic thin film is formed of a loop body.

Also, according to the present invention, in the magnetic field sensor, the magnetic thin film is formed of a square loop body, and the feeder allows the current to flow in a diagonal direction of the square.

Also, according to the present invention, in the magnetic field sensor, the magnetic thin film is of a loop body, and has a uniform line width.

Also, according to the present invention, in the magnetic field sensor, the magnetic thin film comprises an internal magnetic thin film provided in the loop body and made of a magnetic film.

Also, according to the present invention, in the magnetic field sensor, the internal magnetic thin film comprises a magnetic thin film made of the same material as that of the magnetic thin film.

Also, according to the present invention, in the magnetic field sensor, the internal magnetic thin film comprises a magnetic thin film different from the magnetic thin film.

Also, according to the present invention, there is provided a magnetic field measurement method including supplying element current such that a pattern of a magnetic thin film is symmetric about a direction of the element current, and detecting a voltage between ends of the magnetic thin film in a direction perpendicular to a direction of supplying the element current, thereby measuring a magnetic field intensity.

Under the circumstances, according to the present invention, there is provided a power measurement device comprising: a magnetic field sensor comprising a magnetic thin film arranged in parallel to a primary conductor in which AC current flows, a feeder connected to the primary conductor, and comprising input and output terminals configured to supply element current to the magnetic thin film through a resistor, and a detector configured to detect outputs from ends of the magnetic thin film; and a DC component extractor configured to extract a DC component from an output of the detector.

Also, according to the present invention, in the power measurement device, the magnetic field sensor is formed on the same substrate as that of the DC component extractor.

Also, according to the present invention, in the power measurement device, the magnetic thin film of the magnetic field sensor is formed on the substrate, and the detector is connected directly to a wiring pattern on the substrate.

Also, according to the present invention, in the power measurement device, the magnetic field sensor comprises the magnetic thin film formed on the substrate, the feeder comprising the input and output terminals configured to supply element current to the magnetic thin film, and a detection electrode configured to detect the outputs from the ends of the magnetic thin film, in which the wiring pattern is formed by the same conductor layer as that of the feeder and the detection electrode.

Also, according to the present invention, in the power measurement device, the magnetic thin film is formed such that a magnetic resistor is symmetric about a direction of the element current.

Also, according to the present invention, in the power measurement device, the magnetic thin film has a magnetization direction identical with a direction of the element current.

Also, according to the present invention, in the power measurement device, the detector is formed in a direction perpendicular to a direction of the element current.

Also, according to the present invention, in the power measurement device, the DC component extractor comprises an integrator configured to integrate an output value every 1/f periods when a commercial frequency is f.

Also, according to the present invention, the power measurement device comprises a zero-cross point detector configured to detect a zero-cross point of a primary voltage of the element current, in which a drive timing of the DC component extractor is determined according to an output of the zero-cross point detector.

Also, according to the present invention, the power measurement device comprises a capacitor connected in parallel to the detector.

Also, according to the present invention, there is provided a power measurement method using the above-described power measurement device, comprising: supplying element current to a pattern of a magnetic thin film such that a magnetic resistance is symmetric about a direction of the element current; and extracting a DC component of an output generated by supply of the element current, thereby taking the extracted DC component as electric power information.

According to the present invention, there is provided a magnetic field sensor comprising: a magnetic thin film; a feeder comprising an input and output terminals configured to supply element current to the magnetic thin film; and a detector configured to detect a voltage across the magnetic thin film (between ends thereof) in a direction perpendicular to a direction of the element current, wherein the magnetic thin film is formed symmetric about the direction of the element current.

Also, according to the present invention, in the magnetic field sensor, the magnetic thin film has a circular contour.

Also, according to the present invention, in the magnetic field sensor, the magnetic thin film is formed of a loop body.

Also, according to the present invention, in the magnetic field sensor, the magnetic thin film is formed of a square loop body, and the feeder allows the current to flow in a diagonal direction of the square.

Also, according to the present invention, in the magnetic field sensor, the magnetic thin film is of a loop body, and has a uniform line width.

Also, according to the present invention, in the magnetic field sensor, the magnetic thin film is formed of a square loop body, and the feeder allows the current to flow in a diagonal direction of the square.

Also, according to the present invention, in the magnetic field sensor, the magnetic thin film comprises an internal magnetic thin film provided in the loop body and made of a magnetic film.

Also, according to the present invention, in the magnetic field sensor, the internal magnetic thin film comprises a magnetic thin film made of the same material as that of the magnetic thin film.

Also, according to the present invention, in the magnetic field sensor, the internal magnetic thin film comprises a magnetic thin film different from the magnetic thin film.

Also, according to the present invention, there is provided a magnetic field measurement method of the power measurement device, comprising supplying element current such that a pattern of a magnetic thin film is symmetric about a direction of the element current, and detecting a voltage between ends of the magnetic thin film in a direction perpendicular to a direction of supplying the element current, thereby measuring a magnetic field intensity.

### Advantages of the Invention

As described above, according to the magnetic field sensor of the present invention, because a voltage is extracted from points perpendicular to the element current direction with an extremely simple configuration, a direction of a magnetic field can be detected, and a magnetic field can be detected with high reliability.

Also, according to the magnetic field sensor of the present invention, the electric power can be extracted directly by extracting the DC component of the output voltage with the extremely simple configuration with no need to separately measure the power factor.

### Brief Description of the Drawings

FIG. 1 is an illustrative view of a principle of a magnetic field sensor according to the present invention.
FIG. 2 is an illustrative diagram of a principle of a magnetic field sensor according to a first embodiment of the present invention.
FIG. 3 is a top view of the magnetic field sensor according to the first embodiment of the present invention.
FIG. 4 is a cross-sectional view of the magnetic field sensor according to the first embodiment of the present invention.
FIG. 5 is an illustrative view of a circuit illustrating a measurement device for measuring an element characteristic of the magnetic field sensor according to the first embodiment of the present invention.
FIG. 6 is a diagram illustrating measured results of the element characteristic of the magnetic field sensor according to the first embodiment of the present invention.
FIG. 7 is a diagram illustrating the measured results of the element characteristic of the magnetic field sensor according to the first embodiment of the present invention.
FIG. 8 is a diagram illustrating a relationship between a current value and an output voltage in the magnetic field sensor according to the first embodiment of the present invention.
FIG. 9 is an illustrative diagram of a principle of a magnetic field sensor according to a second embodiment of the present invention.
FIG. 10 is a top view of the magnetic field sensor according to the second embodiment of the present invention.
FIG. 11 is a cross-sectional view of the magnetic field sensor according to the second embodiment of the present invention.
FIG. 12 is a cross-sectional view of a magnetic field sensor according to a modified example of the second embodiment of the present invention.
FIG. 13 is a top view of the magnetic field sensor according to the modified example of the second embodiment of the present invention.
FIG. 14 is an illustrative diagram of a principle of a magnetic field sensor according to a third embodiment of the present invention.
FIG. 15 is a top view of the magnetic field sensor according to the third embodiment of the present invention.
FIG. 16 is an illustrative diagram of an outline of a power measurement device according to a fourth embodiment of the present invention.
FIG. 17 is a diagram of an equivalent circuit thereof.

FIG. 18 is an illustrative view of the power measurement device.

FIG. 19 is a cross-sectional view of the power measurement device.

FIG. 20 is a diagram illustrating an output characteristic of the power measurement device.

FIG. 21 is an illustrative view illustrating an output extracting direction of the power measurement device, in which FIGS. 21 (a) and 21 (b) are diagrams when a direction of spontaneous magnetization is parallel to a direction of element current $I_2$, and FIGS. 21(c) and 21(d) are diagrams when the direction of spontaneous magnetization is not parallel to the direction of the element current $I_2$,

FIG. 22 is a diagram illustrating a relationship between an external magnetic field and an output voltage in the power measurement device.

FIG. 23 is an illustrative view of a detector of the power measurement device.

FIG. 24 is an illustrative view of the detector of the power measurement device, in which FIG. 24(a) is a diagram when $\theta$ is 0, and FIG. 24(b) is a diagram when $\theta$ is $\pi/4$.

FIG. 25 is a diagram illustrating an output value for one cycle when an electric power of the power measurement device is extracted as an output.

FIG. 26 is an illustrative view of a power measurement device according to a fifth embodiment of the present invention.

FIG. 27 is an illustrative view of a power measurement device according to a sixth embodiment of the present invention.

FIG. 28 is an illustrative view of a magnetic field sensor in a conventional example.

## Mode for Carrying Out the invention

Hereinafter, embodiments of the present invention will be described in detail with reference to the drawings. Prior to the description of the embodiments of the present invention, a measurement principle of a magnetic field sensor according to the present invention will be described.

In the magnetic field sensor according to the present invention, an output is extracted from a ferromagnetic thin film used as a magnetic thin film in a direction perpendicular to an element current direction, and the ferromagnetic thin film is substantially symmetric about the output extracting direction.

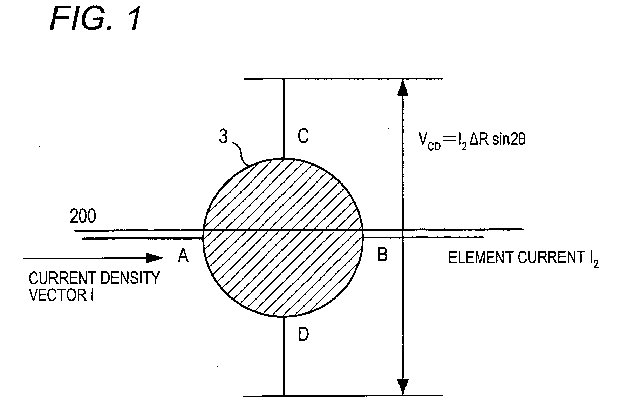

That is, as illustrated in the principle illustrative view of FIG. 1, a circular ferromagnetic thin film 3 is located symmetrically about a center of a pattern of the ferromagnetic thin film 3, and points A and B on a periphery of the ferromagnetic thin film pattern function as current carrying parts, and a segment CD that is perpendicular to a segment AB and passes through a center of a circle is set as the output extraction direction.

In this situation, as illustrated in FIG. 1, it is assumed that current $I_1$ flows in a conductor 200 arranged on the ferromagnetic thin film 3 along a diametric direction thereof. It is assumed that when a magnetic field vector developed by that current is H, and a spontaneous magnetization vector of an element is M, a magnetic flux density vector in which the magnetic field vector H and the spontaneous magnetization vector M of the element are combined together is $B_{MO}$, an angle formed between a current density vector I and the magnetic flux density vector $B_{MO}$ is $\theta$, a resistor between points A and B of the ferromagnetic thin film 3 is R, and a maximum of a resistance value between the points A and B which is changed according to a magnetic field is $\Delta R$, a voltage $V_{CD}$ between the points C and D can be represented by a difference between a voltage $V_{AC}$ and a voltage $V_{AD}$.

When the voltage $V_{CD}$ can be represented by the numerical expression as follows

$$V_{CD}=I_2(\Delta R\sin 2\theta) \qquad \dots \quad (3)$$

where $I_2$ is element current.

That is, when an AC magnetic field is applied, positive and negative can be determined.

Also, as compared with a case of the conventional example represented by Expression (1), because an offset when no magnetic field is applied does not occur, and becomes zero, a circuit configuration can be simplified.

According to this configuration, it is assumed that the current $I_1$ flows in the conductor 200 arranged on the ferromagnetic thin film 3 along the diametric direction thereof, the magnetic field developed by that current is H, and the spontaneous magnetization of the element is M. In this case, when it is assumed that the magnetic flux density vector in which the external magnetic field vector H and the spontaneous magnetization vector M of the element are combined together is $B_{MO}$, the angle formed between the current density vector I and the magnetic flux density vector $B_{MO}$ is $\theta$, the resistor between the points A and B of the ferromagnetic thin film 3 is R, and the maximum of the resistance value between the points A and B which is changed according to the magnetic field is $\Delta R$, the voltage $V_{CD}$ between the points C and D can be represented by the difference between the voltage $V_{AC}$ and the voltage $V_{AD}$.

(First Embodiment)

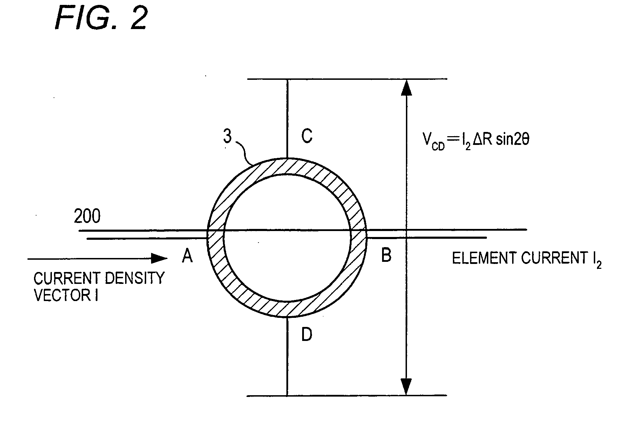

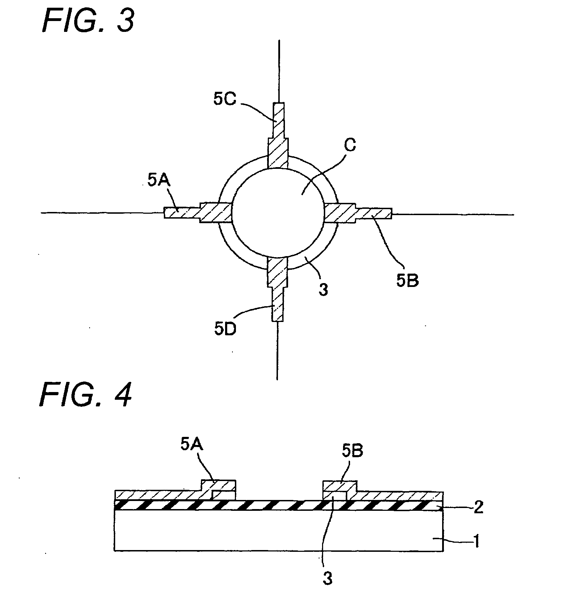

The magnetic field sensor according to a first embodiment will be described. FIG. 2 illustrates an illustrative view of a principle of the magnetic field sensor, FIG. 3 illustrates a top view thereof, and FIG. 4 illustrates a cross-sectional view thereof. As illustrated in FIGS. 3 and 4, a silicon oxide film is formed as an insulating film 2 on a surface of a substrate 1 made of silicon, a loop pattern of the ferromagnetic thin film 3 having a ferromagnetic characteristic is formed on the insulating film 2, and a conductor pattern configuring feeders 5A and 5B along the diametric direction of the loop pattern, and a conductor pattern as detectors 5C and 5D formed in a direction perpendicular to a direction of the element current supplied from the feeders 5A and 5B are provided.

That is, as illustrated in the principle illustrative view of FIG. 2, the circular ferromagnetic thin film 3 is located symmetrically about the center of the pattern of the circular ferromagnetic thin film 3, and the points A and B on the periphery of the ferromagnetic thin film pattern function as current carrying parts, and the segment CD that is perpendicular to the segment AB and passes through the center of the circle is set as the output extraction direction.

In this situation, as illustrated in FIG. 2, it is assumed that the current $I_1$ flows in the conductor 200 arranged on the ferromagnetic thin film 3 along the diametric direction thereof. It is assumed that when the magnetic field developed by that current is H, and the spontaneous magnetization of the element is M, the magnetic flux density vector in which the external magnetic field vector H and the spontaneous magnetization vector M of the element are combined together is $B_{MO}$, the angle formed between the current density vector I and the magnetic flux density vector $B_{MO}$ is θ, the resistor between points A and B of the ferromagnetic thin film 3 is R, and the maximum of the resistance value between the points A and B which is changed according to the magnetic field is $\Delta R$, the voltage $V_{CD}$ between the points C and D can be represented by the difference between the voltage $V_{AC}$ and the voltage $V_{AD}$.

Accordingly, when the above Expression (3) is satisfied, and the AC magnetic field is applied, positive and negative can be determined.

Also, because an offset when no magnetic field is applied does not occur, and becomes zero, a circuit configuration can be simplified.

In this example, the ferromagnetic thin film is selected from an antiferromagnetic (coupled) thin film of a (ferromagnetic material/antimagnetic conductor) structure, an induced ferromagnetic (uncoupled) thin film of a (high coercivity ferromagnetic material/nonmagnetic material/low coercivity ferromagnetic material) structure, a spin valve thin film of a (semi-ferromagnetic material/ferromagnetic material/nonmagnetic conductor/ferromagnetic material) structure, or a non-solid solution granular thin film of a Co/Ag system, in addition to the ferromagnetic thin film of a single layer structure. Also, the conductor pattern is made of gold, copper, or aluminum.

Subsequently, a process of manufacturing the magnetic field sensor will be described.

A silicon oxide film is formed as the insulating film 2 on a surface of a silicon substrate as the substrate 1, and the ferromagnetic thin film 3 is formed on an upper layer thereof through a sputtering technique. In this situation, sputtering is conducted while applying a magnetic field so as to align spontaneous magnetization directions.

Then, the ferromagnetic thin film 3 is patterned through photolithography to form a loop pattern.

Thereafter, a conductive thin film made of gold or the like is formed through the sputtering technique, and patterned through photolithography to form the feeders 5A, 5B and the detectors 5C, 5D as illustrated in FIGS. 3 and 4.

Then, a proactive film is formed as the occasion demands to complete the magnetic field sensor.

According to the magnetic field sensor of this embodiment, because a width of the magnetic thin film is reduced, an electric resistance is increased so that the output can increase.

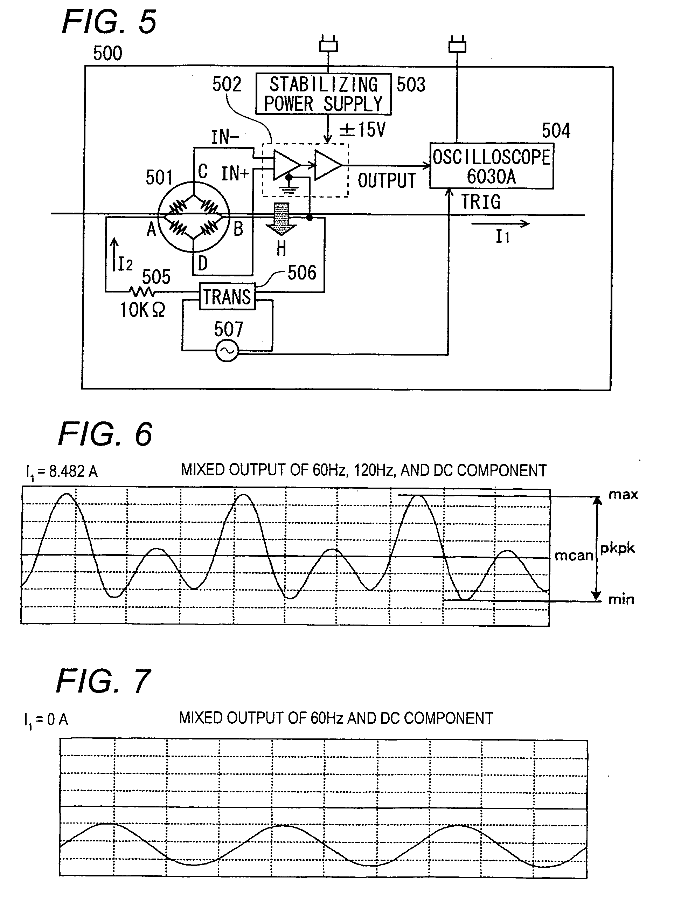

For the purpose of confirming the output characteristic of the magnetic field sensor, experiment has been conducted by using the measurement device illustrated in FIG. 5. AC current is supplied to the feeders A and B of a magnetic field sensor 501 illustrated in FIGS. 2 to 4 from an AC power supply 507 through a transformer 506 and a resistor 505. Also, an oscilloscope 504 as a display unit is connected to the detectors C and D of the magnetic field sensor 501 through an amplifier 502. Reference numeral 503 denotes a stabilizing power supply. The measurement device is housed in a casing 500 made of ion. In this example, the measurement has been conducted under the conditions in which an element substrate on which this element is mounted is arranged vertically, and a distance between the element and a current wire to be measured is set to about 3mm.

The measured results are illustrated in FIGS. 6 and 7. FIG. 6 illustrates an instantaneous output when the element current $I_1$ is set to 8.842 A, and FIG. 7 illustrates the instantaneous output when the element current $I_1$ is set to 0A.

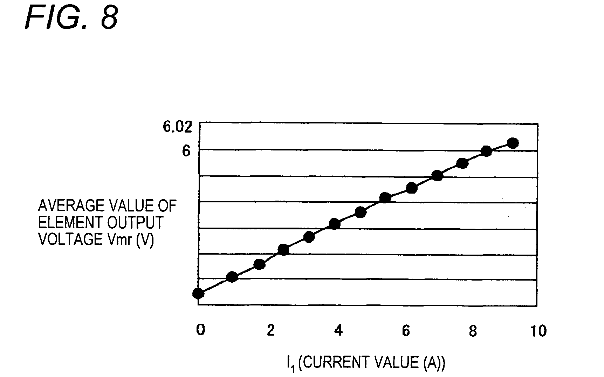

A relationship between current values thus obtained and the element output voltages is illustrated in FIG. 8. In this example, an offset by the amplifier is 5.888V, but in other cases, no offset occurs, and the reliability is high.

In the above embodiment, the measurement using the element substrate arranged vertically is described. Alternatively, measurement may be conducted by mounting an electric wire to be measured on the element substrate.

Also, in the above embodiment, it is desirable that a line width is constant. If the line width is not constant, it is effective that a film thickness is adjusted or an auxiliary pattern is added so that a resistance value is symmetric.

Also, because the magnetic thin film is circular in contour and symmetric, the magnetic thin film is easily so formed as to be symmetric about element current direction. This makes it possible to provide the magnetic field sensor with high reliability.

Also, when the magnetic thin film is loop shape, a width of the magnetic thin film becomes smaller, and the electric resistance is increased. As a result, the resistance value can be increased without increasing the contour of the element, and the output can be increased.

(Second Embodiment)

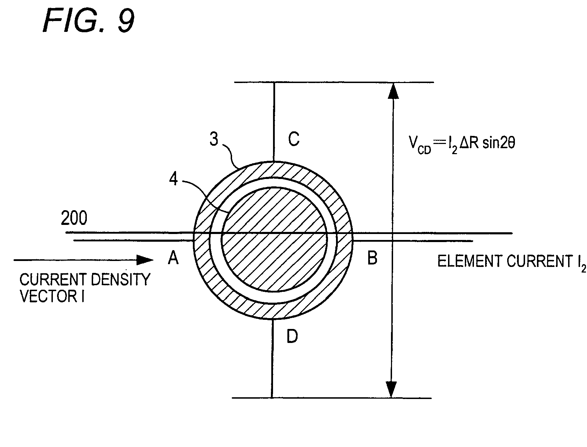

Subsequently, a second embodiment of the present invention will be described. In this embodiment, as illustrated in FIGS. 9 to 11, an auxiliary pattern 4 of a ferromagnetic thin film is formed as a circular inner magnetic thin film having a similar figure along an inner periphery of a ring of the ferromagnetic thin film 3 configuring the loop pattern of the magnetic field sensor in the first embodiment.

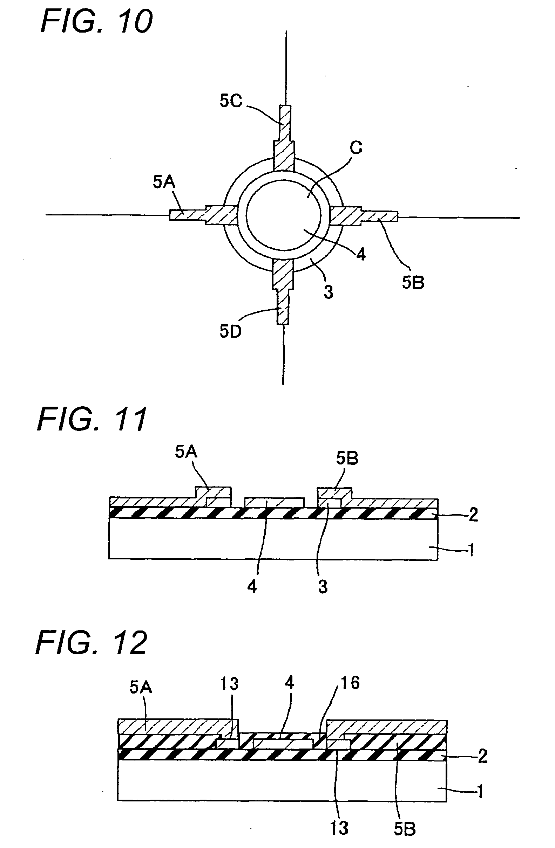

In this configuration, the auxiliary pattern 4 is merely added, and the other configurations are identical with those in the first embodiment, and their description will be omitted. The same parts are denoted by identical symbols. FIG. 9 illustrates an illustrative view of a principle of the magnetic field sensor, FIG. 10 illustrates a top view thereof, and FIG. 11 illustrates a cross-sectional view thereof. With presence of the auxiliary pattern 4, a magnetic sensitivity is enhanced while the electric resistance is kept high. An outer loop pattern that is the ferromagnetic thin film 3 and the inner auxiliary pattern 4 come out of electric contact with each other. For that reason, the electric resistance is identical with that of the magnetic field sensor in the first embodiment, but a space is magnetically embedded with the magnetic thin film. As a result, more magnetic flux can be introduced, and the sensitivity can be enhanced.

Thus, according to this embodiment, because the space is formed between the magnetic materials, the sensitivity to the external magnetic field is deteriorated. Under the circumstances, for the purpose of improving only the magnetic sensitivity while keeping the high electric resistance, the inner magnetic thin film is provided electrically independently with the result that the sensitivity can be more enhanced.

As an element structure, as illustrated in a modified example of FIG. 12, after a magnetic thin film pattern has been formed, an entire substrate surface is coated with a protective insulating film 16 made of polyimide resin, and the feeders 5A, 5B and the detectors 5C, 5D may be formed via through holes. This configuration makes it possible to provide the magnetic field sensor that prevents the deterioration of the magnetic thin film and is high in reliability.

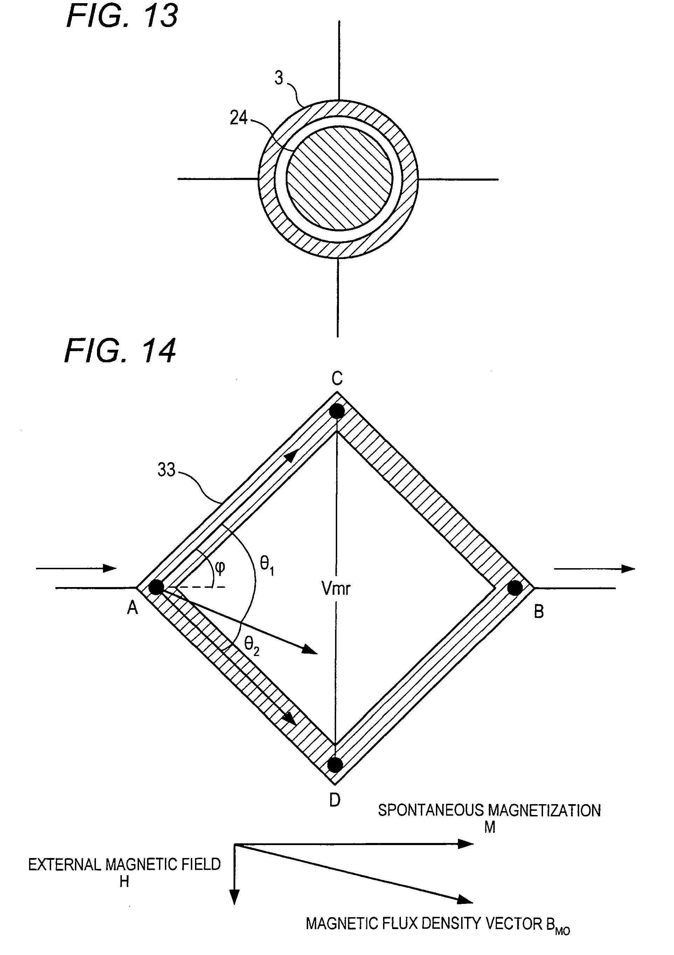

Furthermore, the auxiliary pattern formed inside the loop pattern may be made of the same material, or an auxiliary pattern 24 may be formed of a magnetic thin film made of a different material as illustrated in FIG. 13.

Since the inner magnetic thin film, that is, the auxiliary pattern is formed of a magnetic thin film made of the same material as that of the magnetic thin film, there can be provided the magnetic field sensor that is easy in manufacture, and high in sensitivity and reliability with only a change in the pattern.

Also, the sensitivity can be adjusted by forming the inner magnetic thin film, that is, the auxiliary pattern of the magnetic thin film different from the magnetic thin film. Also, when a large number of magnetic field sensors are aligned, the sensitivity can be adjusted by adjusting a material of the inner magnetic thin film for the purpose of uniforming the sensitivity.

The protective film can be formed of an organic film made of polyimide resin or novolac resin in addition to the silicon oxide film and an inorganic film made of aluminum oxide.

(Third Embodiment)

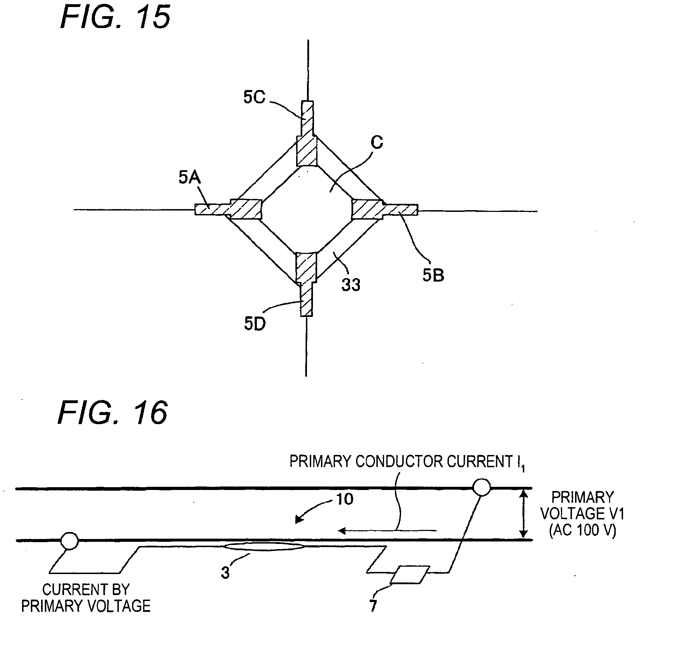

Subsequently, a third embodiment of the present invention will be described. In this embodiment, as illustrated in FIGS. 14 and 15, the ferromagnetic thin film is configured by a square loop pattern 33, the feeders 5A and 5B are located so that current flows in a diagonal direction of the square, and the detectors 5C and 5D are formed in a direction perpendicular to the diagonal direction.

Similarly, in this embodiment, the loop pattern 3 of the magnetic field sensor according to the first embodiment is merely replaced with the square loop pattern 33, and the other configurations are identical with those in the first embodiment, and their description will be omitted. The same parts are denoted by identical symbols. FIG. 14 is an illustrative view of a principle of the magnetic field sensor, and FIG. 15 is a top view thereof.

In this example, a magnetic flux density vector is a combination of the spontaneous magnetization vector M of the element and the external magnetic field vector H, and when there is no external magnetic field, the magnetic flux density vector is in the spontaneous magnetization vector direction. When the external magnetic field is an AC magnetic field, the element vibrates in a vertical direction of the drawing, centering around on the spontaneous magnetization vector.

According to this configuration, an output Vmr of the sensor can be represented by the following Expression. As in the above description, it is assumed that angles formed between the current density vector and the magnetic flux density vector are $\theta_1$ and $\theta_2$, angles formed between AB and AC, and AB and AD are $\phi$, a voltage between A and C is $V_{ACo}$ and a voltage between A and D is $V_{AD0}$ when there is no external magnetic field, and a maximum value of a voltage change due to the magnetoresistive effect is ΔVr.

(Math. 2)

$$Vmr = V_{AC} - V_{AD}$$
$$= \{V_{AC0} + \Delta Vr \cos 2\theta_1\} - \{V_{AD0} + \Delta Vr \cos 2\theta_2\}$$
$$= \{V_{AC0} + \Delta Vr \cos 2\theta_1\} - \{V_{AD0} + \Delta Vr \cos 2(\theta_1 - 2\phi)\}$$

$$(4)$$

When $V_{AC0} = V_{AD0}$, $Vmr$ is obtained as follows:
$$Vmr = \Delta Vr \cos 2\theta_1 - \Delta Vr \cos 2(\theta_1 - 2\phi)$$

$$(5)$$

When $2\phi = 90°$, a maximum value of $Vmr$ is obtained as follows:
$$Vmr = \Delta Vr \cos 2\theta_1 - \Delta Vr \cos 2(\theta_1 - 90°)$$
$$= \Delta Vr \cos 2\theta_1 - \Delta Vr \cos(2\theta_1 - 180°)$$
$$= \Delta Vr \cos 2\theta_1 + \Delta Vr \cos 2\theta_1$$
$$= 2\Delta Vr \cos 2\theta_1$$

$$(6)$$

A round loop shape, that is, a circular loop shape can be also expressed by substantially the same expression. However, in the case of the round loop shape, a direction of the current density vector is changed from A toward C, and from A toward D. Because components other than $\phi$=45 where the output is maximum also exist, the output becomes smaller than that in the case of the square shape.

In the above embodiment, the magnetic thin film is formed through the sputtering technique, but may be formed through a vacuum evaporation technique, a coating method, or a dipping method without limit to the sputtering technique.

Also, the substrate may be formed of not only a semiconductor substrate made of silicon, but also an inorganic substrate made of sapphire, glass, or ceramic, or an organic substrate made of resin. In particular, it is preferable to use the semiconductor that is excellent in so-called flexibility, thin, and lightweight among those substrates. For example, the same substrate as a plastic film widely used as a printed wiring board can be used. More specifically, as a plastic film material, various known materials, for example, polyimide, polyethylene terephthalate (PET), polypropylene (PP), and Teflon (registered trademark) are available.

Furthermore, the magnetic thin film pattern may be formed directly on a substrate such as a glass substrate to form the magnetic field sensor. Alternatively, a chip may be formed once, and implemented in the glass substrate or the printed wiring board through a wire bonding technique or a flip chip technique. Also, the magnetic field sensor with high precision and high reliability can be provided by integrating a processing circuit within the chip.

The present invention is not limited to the above embodiment, but may be applied to a configuration in which the output extracting direction of the magnetic thin film is perpendicular to the element current direction, and the magnetic resistance is symmetric about the direction of the element current. With this configuration, the positive and negative of the direction can be determined, and the circuit configuration can be simplified because the offset when no magnetic field is applied is eliminated.

Also, in the above embodiment, the magnetic field sensor using the ferromagnetic thin film is used. However, the present invention is not limited to this sensor, but other magnetic field sensors may be used.

(Fourth Embodiment)

Prior to the description of the embodiment of the present invention, a measurement principle of the present invention will be described.

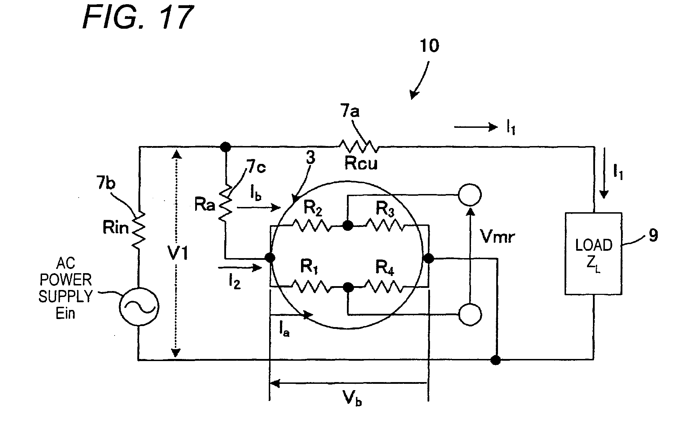

In the power measurement device, a signal component proportional to an electric power is extracted paying attention to a fact that a linear characteristic can be obtained with no bias magnetic field, by the aid of a planar hall effect that is a phenomenon in which an electric resistance value of the magnetic material is changed according to an angle formed between current and magnification. FIGS. 16 and 17 illustrate the measurement principle. FIG. 16 is an illustrative diagram of an outline of the power measurement device, and FIG. 17 is a diagram of an equivalent circuit thereof.

The magnetic field sensor used in this example is an element that converts a change in the external magnetic field into an electric signal, which patterns a ferromagnetic thin film 5 as a magnetic field detection film, and allows current to flow in a pattern of the magnetic field detection film to convert a change in the external magnetic field into an electric signal as a voltage change.

In this example, as illustrated in FIG. 17, the ferromagnetic thin film can be regarded as a resistor bridge including $R_1$, $R_2$, $R_3$, and $R_4$.

In this example, in an equilibrium state ($R_1=R_2=R_3=R_4$), the following expression is satisfied.

(Math. 3)

Currents flowing through elements are defined as *Ia*, *Ib* as follows :

$$Ia = \frac{Vb}{R1+R4}, Ib = \frac{Vb}{R2+R3}$$

The output voltage *Vmr* is obtained as follows :

$$Vmr = Ia \cdot R1 - Ib \cdot R2$$

$$= R1 \cdot \frac{Vb}{R1+R4} - R2 \cdot \frac{Vb}{R2+R3}$$

$$= \frac{R1 \cdot R3 - R2 \cdot R4}{(R1+R4)\cdot(R2+R3)} \cdot Vb$$

When $R1$ is changed to $(R1 + \Delta R1)$ :

$$Vmr = \frac{(R1+\Delta R1)\cdot R3 - R2 \cdot R4}{(R1+\Delta R1+R4)\cdot(R2+R3)} \cdot Vb$$

When the numerator and the denominator are divided by $R1 \cdot R3$ :

$$Vmr = \frac{(1+\dfrac{\Delta R1}{R1}) - \dfrac{R2 \cdot R4}{R1 \cdot R3}}{(1+\dfrac{\Delta R1}{R1}+\dfrac{R4}{R1})\cdot(\dfrac{R2}{R3}+1)} \cdot Vb$$

$R1 = R2 = R3 = R4$ :

$$Vmr = \frac{\dfrac{\Delta R1}{R1}}{(2+\dfrac{\Delta R1}{R1})\cdot 2} \cdot Vb = \frac{\Delta R1}{4R1+2\cdot\Delta R1} \cdot Vb$$

$\Delta R1 \ll R1$ :

$$Vmr = \frac{\Delta R1}{4R1} \cdot Vb \tag{7}$$

$$\Delta R1 = k \cdot I1, Vb = R1 \cdot I2 :$$

$$Vmr = \frac{1}{4R1} \cdot (k \cdot I1) \cdot (R1 \cdot I2) = \frac{1}{4R1} \cdot (k \cdot I1) \cdot (R1 \cdot I2)$$

$$= \frac{k}{4} \cdot I1 \cdot I2$$

$$\text{when } i_1(t) = \sqrt{2}I_1 \cos(\omega t + \theta), i_2(t) = \sqrt{2}I_2 \cos \omega t, \text{ and}$$

$$\text{expanded similar to principal equation of magnetoresistive effect as follows :}$$

$$= \frac{k}{4} I_1 I_2 \cos \theta + \frac{k}{4} \cdot I_1 I_2 \cos(2\omega t + \theta)$$

$$\text{Because } I_2 \cong \frac{V_2}{Ra} :$$

$$Vmr = \frac{k}{4 \cdot Ra} \cdot I_1 \cdot V_2 \cos \theta + \frac{k}{4 \cdot Ra} \cdot I_1 \cdot V_2 \cos(2\omega t + \theta) \qquad (8)$$

Accordingly, the expression is divided into a term of a DC component (first term) and a term of an AC component (second term).
That is, when the resistance bridge is zero in magnetic field, and Vmr=0 is satisfied ($R_1=R_2=R_3=R_4$), the output Vmr developed by the applied magnetic field is proportional to a resistance change rate.

This is because of the following reason.

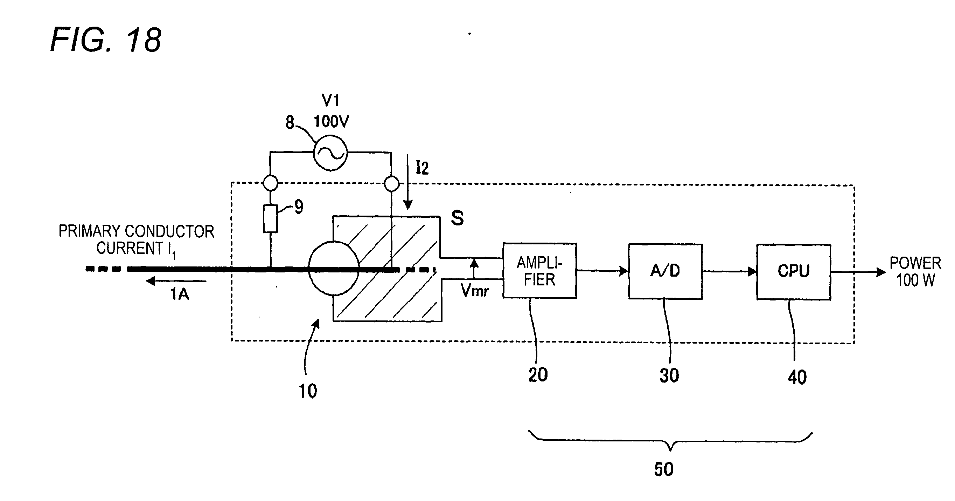

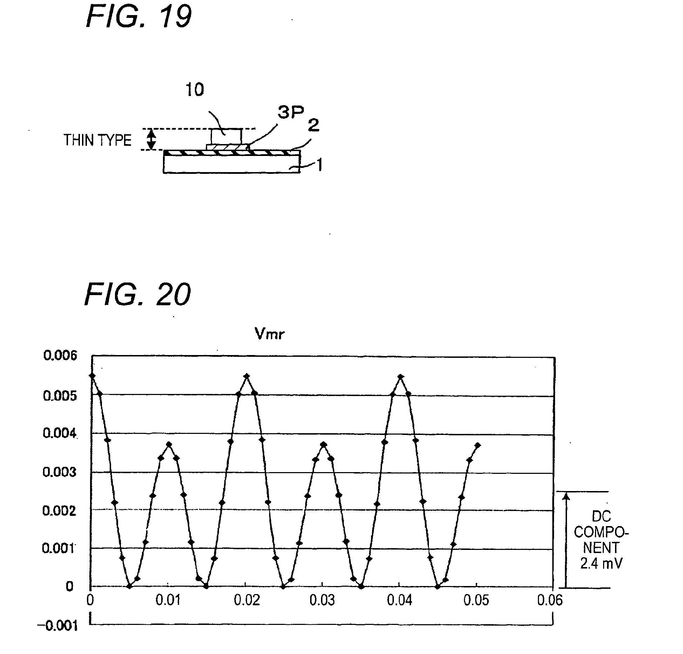

Because the power measurement device can be designed so that resistance change rate $\Delta R_1/R_1$ is proportional to $I_1$, and the voltage Vb applied to the ferromagnetic thin film is proportional to $I_2$, the output Vmr is proportional to a product of $I_1$ and $I_2$. That is, the output Vmr is a signal component proportional to the electric power. When $I_1$ and $I_2$ are expanded in an instantaneous expression, Vmr is (DC term) + ($2\omega$ term).
Because the resistance bridge is generally unbalanced, the output Vmr appears as a $\omega$ term, but its component is irrelevant to the electric power. More precisely, since the output Vmr becomes a larger value as the unbalance is larger, the degree of unbalance and the electric power component can be separated from each other.
Under the circumstances, the electric power can be extracted directly with extraction of the term of the DC component which is the first term.
The magnetic field sensor used in the power measurement device according to the present invention is described in the first embodiment, and therefore its description will be omitted below.
The power measurement device according to the fourth embodiment will be described. FIG. 18 illustrates an illustrative view of the power measurement device, FIG. 19 illustrates a cross-sectional view thereof, and FIG. 20 illustrates the output of the power measurement device. The power measurement device includes a magnetic field sensor 10 having a ferromagnetic thin film that is arranged in parallel to a primary conductor into which AC current flows, a feeder that is connected to the primary conductor, and has an input and output terminal that supplies element current to the ferromagnetic thin film through a resistor, and a detector that detects outputs from ends of the ferromagnetic thin film, and a DC component extractor 50 that extracts a DC component from an output of the detector.
In this example, the feeder of the magnetic field sensor 10 is connected to an AC power supply 8 through a resistor 9 as a load. Also, the DC component extractor 50 connected to the detector includes an amplifier 20, an A/D converter 30, and a CPU 40.
Also, the power measurement device includes the magnetic field sensor 10 that is mounted on a circuit board 1 that is a printed wiring board through a wiring pattern 3P, the amplifier 20 formed of chip parts connected to the wiring pattern 3P on the printed wiring board by soldering, the A/D converter 30, and the CPU 40 connected to each other. Reference numeral 2 denotes an insulating film.
In this example, as illustrated in FIG. 18, because the magnetic field sensor is formed on the circuit board 1 together with the DC component extractor 50, a surface A surrounded by the ferromagnetic thin film of the magnetic field sensor and an input wire of the amplifier 20 does not intersect with a magnetic flux developed by the primary conductor current $I_1$. As a result, an influence of an unnecessary induced electromotive force caused by an interlinkage magnetic flux can be reduced. Also, the power measurement device can be thinned and downsized.
The output thus obtained is illustrated in FIG. 20. The electric power can be directly obtained by obtaining a DC component from the output Vmr.

According to the power measurement device of this embodiment, the signal component proportional to the electric power is extracted paying attention to a fact that the linear characteristic can be obtained with no bias magnetic field, by the aid of the planar hall effect that is a phenomenon in which the electric resistance value of the magnetic material is changed according to the angle formed between the current and the magnification within the ferromagnetic material. The DC component is extracted from the output of the detector by the DC component extractor. For that reason, the extracted waveform is current × voltage × power factor component, and therefore the electric power, and the electric power can be measured directly from the waveform without multiplication. Therefore, the power detection can be realized with ease and high precision.

Also, according to the present invention, in the power measurement device, the ferromagnetic thin film is formed so that the magnetic resistance is symmetric about the direction of the element current.

(Math. 4)

$$V_{mr} = \underbrace{\frac{R1 \cdot R3 - R2 \cdot R4}{R1 + R2 + R3 + R4} \cdot \sqrt{2}I_2 \cos\omega t}_{\substack{\text{Primary Component} \\ \text{(Unncessary Component)}}}$$

$$+ \underbrace{\frac{k \cdot R3}{R1 + R2 + R3 + R4} \cdot I_1 \cdot V_1 \cos\theta + \frac{k \cdot R3}{R1 + R2 + R3 + R4} \cdot I_1 \cdot V_1 \cos(2\omega t + \theta) + \text{harmonic component}}_{\text{Power Signal}}$$

$$(9)$$

Assuming that the above expression is satisfied, when a magnetic field of $\theta=\pi/4$ is applied, Vmr becomes a maximum value. The signal can be most efficiently extracted when the configuration is symmetric about the output extraction point. Thus, according to the above configuration, because the magnetic resistance is symmetric about the direction of the element current, the maximum value of the output Vmr can be largely taken, and an S/N ratio as the system is improved. Therefore, according to the above configuration, the electric power can be measured with high precision.

Also, it is desirable that the ferromagnetic thin film is formed so that the magnetization direction matches the direction of the element current from the viewpoint of the high sensitivity.

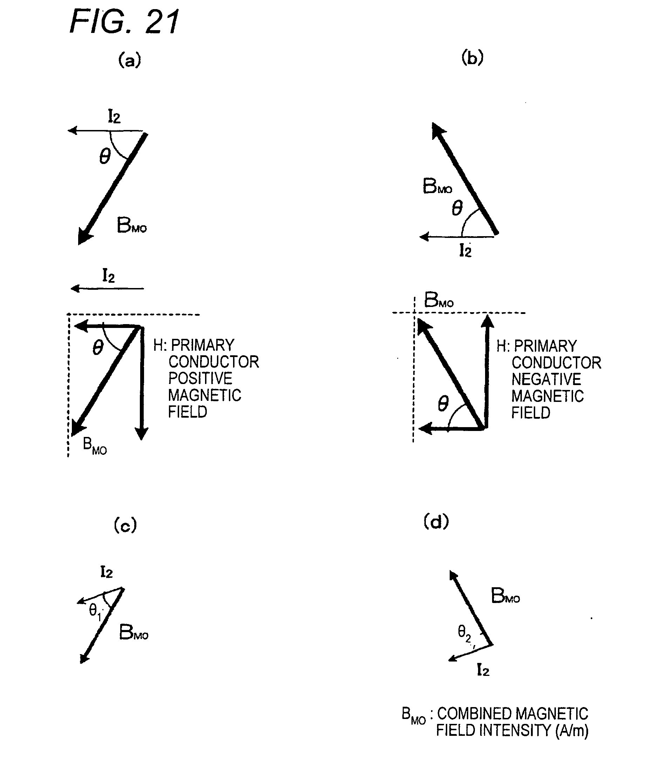

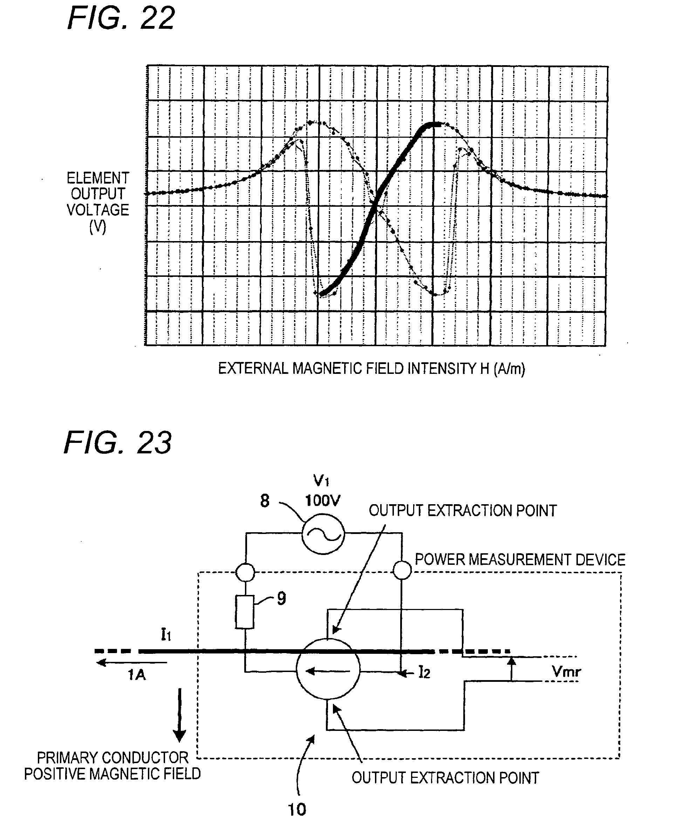

Thus, with production of the spontaneous magnetization, the planar hall effect, that is, the magnetoresistive effect (phenomenon that the resistance value is changed by the magnetic field) occurs in the ferromagnetic thin film. A relationship of the current $I_2$ vector, the direction of the spontaneous magnetization, that is, a magnetic field H due to the primary conductor, and the combined magnetic flux density vector $B_{MO}$ is illustrated in FIG. 21. From this figure, the direction of the spontaneous magnetization is held in parallel to the direction of the element current $I_2$ as illustrated in FIGS. 21(a) and 21(b) whereby the output (absolute value) becomes equal between the maximum value of positive and the minimum value of negative in the magnetic field direction due to the primary conductor, and a dynamic range can be maximized. Lower stages of FIGS. 21 (a) and 21(b) are illustrative views illustrating the generation of combined magnetization of upper stages. On the other hand, unless the direction of the spontaneous magnetization is held in parallel to the direction of the element current $I_2$ as illustrated in FIGS. 21 (c) to 21(d), because any one of the maximum value of positive and the minimum value absolute value) of negative becomes smaller, the dynamic range of the sensor is narrowed. FIG. 22 illustrates the dynamic range by a bold line in the figure in the element output and the magnetic field intensity due to the primary conductor. Because the dynamic range is defined by smaller one of the positive side and the negative side of the element output, when the element current vector $I_2$ is held in parallel to the spontaneous magnetization, the positive side and the negative side become equal to each other, and therefore the overall dynamic range can be most effectively obtained.

In manufacturing, when the film is formed through sputtering, sputtering is conducted while applying the magnetic field so that the direction of the spontaneous magnification is held in parallel to the direction of the element current $I_2$, thereby enabling the film to be easily formed.

According to the above configuration, the signal component proportional to the electric power is extracted paying attention to a fact that the linear characteristic can be obtained with no bias magnetic field, by the aid of the planar hall effect that is a phenomenon in which the electric resistance value of the magnetic material is changed according to the angle formed between the current and the magnification within the ferromagnetic material. The DC component is extracted from the output of the detector by the DC component extractor. For that reason, the extracted waveform is

current $\times$ voltage $\times$ power factor component, and therefore the electric power, and the electric power can be measured directly from the waveform without multiplication. Therefore, the power detection can be realized with ease and high precision.

Also, according to the present invention, in the power measurement device, it is desirable that the detector is formed in the direction perpendicular to the direction of the element current as illustrated in illustrative views of FIGS. 23 to 24.

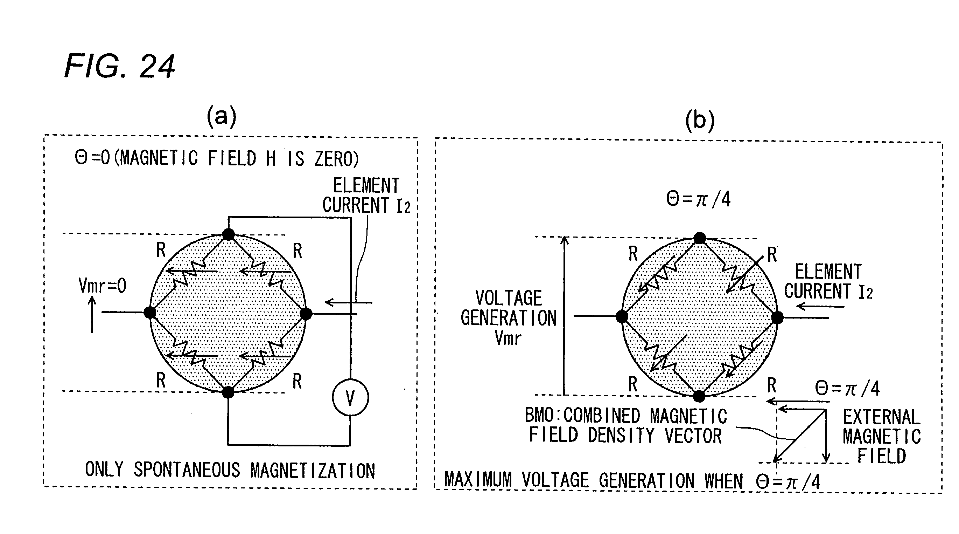

FIG. 24(a) illustrates the detector when the external magnetic field vector H is zero, and FIG. 24(b) illustrates the detector when the external magnetic field vector H has an angle of $\pi/4$.

According to this configuration, when the magnetic field of $\theta=\pi/4$ is applied, Vmr becomes a maximum value, and therefore the signal can be most efficiently extracted when the configuration is symmetric about the output extraction point.

Also, it is desirable that the DC component extractor 50 includes an integrator that integrates the output value every 1/f periods when the commercial frequency is f.

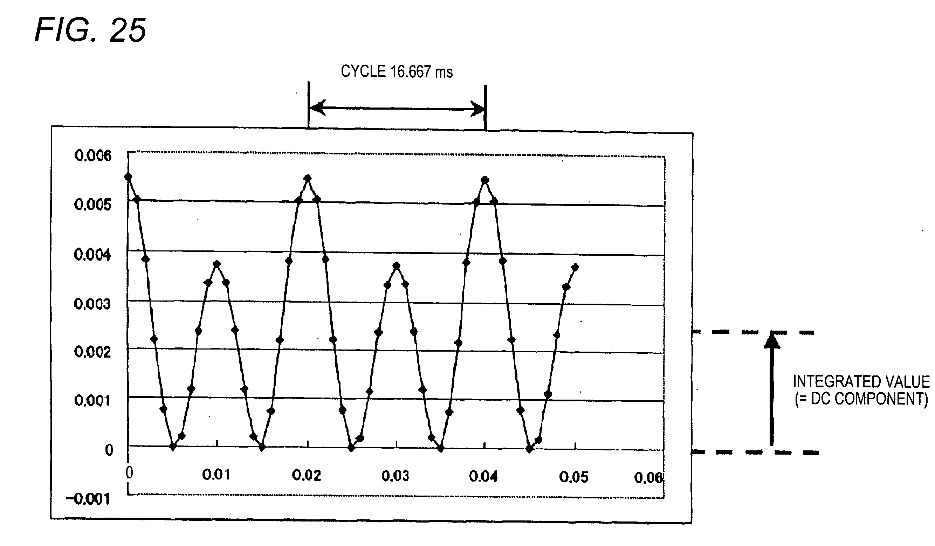

According to the above configuration, since Vmr is a common multiple of (DC component + Commercial frequency), as the output value for one cycle when the electric power of the power measurement device is extracted as the output is illustrated in FIG. 25, if the output value is integrated during the cycle of the commercial frequency, plus and minus of the AC component are offset with each other, and only the DC component can be extracted. Since the DC component can be obtained on the cycle basis, and is suited for fast operation, this configuration is excellent in transient response. Also, when the output value is integrated in a cycle, an unnecessary primary term can be dropped, and a harmonic component of the electric power can be also extracted.

(Fifth Embodiment)

Subsequently, a fifth embodiment of the present invention will be described.

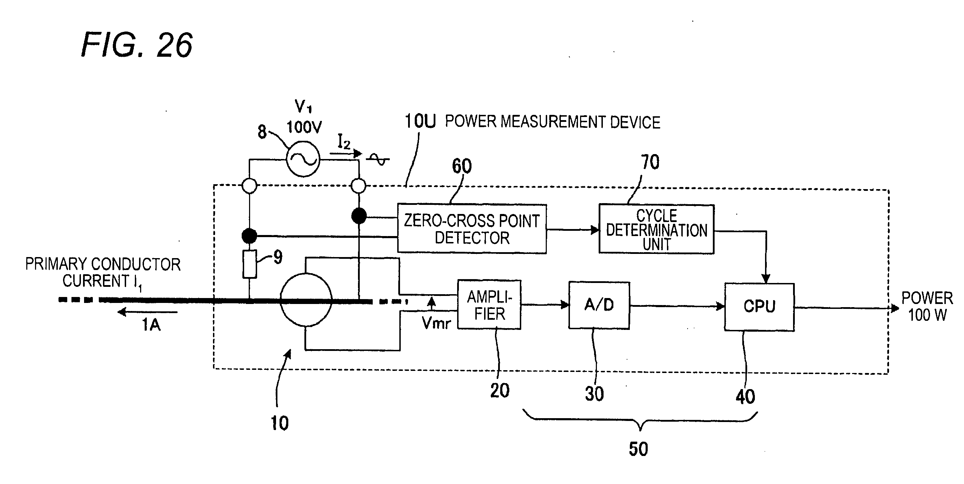

In this embodiment, as illustrated in FIG. 26, the detector of the magnetic field sensor 10 is connected with a zero-cross point detector 60 and a cycle determination unit 70, and a cycle of the output is detected by the cycle determination unit 70 on the basis of an output of the zero-cross point detector. In this example, the cycle is determined by the cycle determination unit 70 according to the output of the zero-cross point detector 60, and a drive timing of the DC component extractor 50 is determined according to the cycle. The other configurations are identical with those in the above fourth embodiment, and therefore their description will be omitted.

According to this configuration, since a system frequency is always varied, the system voltage is used with the highest precision for the purpose of precisely measuring the cycle. A portion where the voltage signal is supplied to the substrate for the element current $I_2$ is branched, thereby enabling the cycle to be detected from the voltage signal without newly providing an external voltage signal line.

(Sixth Embodiment)

Subsequently, a sixth embodiment of the present invention will be described.

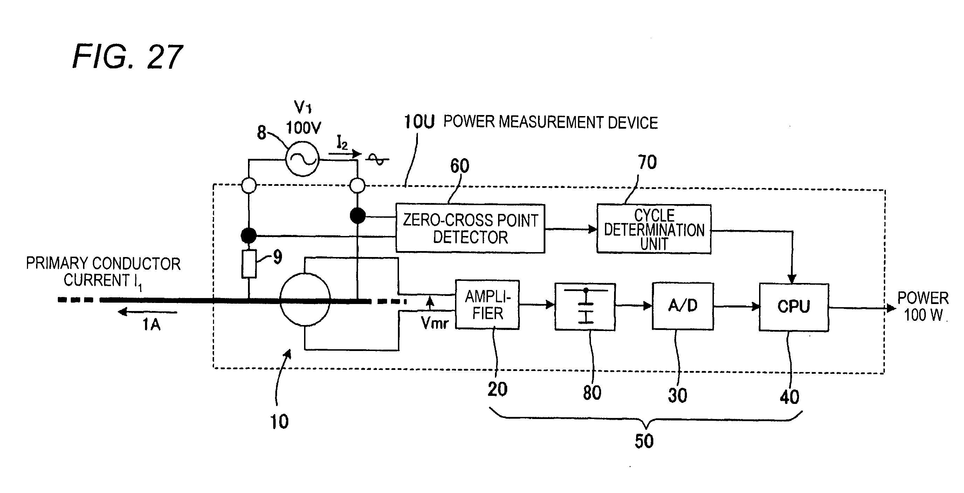

In this embodiment, as illustrated in FIG. 27, in the power measurement device, the detector of the magnetic field sensor is connected in parallel to a capacitor 80. The other configurations are identical with those in the above fourth embodiment, and therefore their description will be omitted.

According to this configuration, since the DC component can be extracted in a shorter period than the cycle by smoothing the Vmr signal by the capacitor, the power value can be obtained at a high speed, and the DC component can be detected with a simple circuit configuration.

(Seventh Embodiment)

Subsequently, a seventh embodiment of the present invention will be described.

In the above fourth embodiment, the magnetic field sensor is configured by chip parts, and mounted on the printed wiring board configuring the circuit board. However, the pattern of the ferromagnetic thin film 3 is formed directly on the printed wiring board 1 configuring the circuit board, and a conductor pattern configuring the feeder and the detector is formed in the same process as that of the wiring pattern, and integrated together. The amplifier, the A/D converter, and the CPU are configured by the chip parts. Alternatively, it is possible that processing circuits are integrated on a silicon substrate, and the magnetic field sensor, and the magnetic field sensor is formed through an insulating film to provide a monolithic element.

According to this configuration, the power measurement device can be more thinned and downsized.

Similarly, it is needless to say that the magnetic field sensor described in the second and third embodiments may be used in the power measurement device described in the fourth to seventh embodiments.

Similarly, in the above power measurement device, with formation of the magnetic thin film on the substrate, the magnetic field sensor and the processing circuits can be integrated by the substrate to further enable thinning and downsizing.

Also, in the above power measurement device, the magnetic field sensor may include a magnetic thin film formed on the substrate, a feeder having an input and output terminal that supplies the element current to the magnetic thin film, and a detection electrode unit that detects outputs from both ends of the magnetic thin film, and the wiring pattern may be configured by the same conductor layer as that of the feeder and the detection electrode unit.

According to this configuration, because the pattern of the magnetic thin film has only to be formed in addition to the configuration of the normal circuit board, the power measurement device can be extremely easily formed.

Also, in the above power measurement device, the magnetic thin film may be formed so that the magnetic resistance is symmetric about the direction of the element current.

According to this configuration, because the magnetic thin film is formed so that the magnetic resistance is symmetric about the direction of the element current, the maximum value of the output Vmr can be largely taken, and the S/N ratio as the system is improved.

Also, in the above power measurement device, a capacitor connected in parallel to the detector may be provided.

According to this configuration, since the DC component can be extracted in a shorter period than the cycle by smoothing the Vmr signal by the capacitor, the power value can be obtained at a high speed, and the DC component can be detected with a simple circuit configuration.

Also, with use of the power measurement device, there is provided a power measurement method including the steps of supplying element current to a pattern of a magnetic thin film so that a magnetic resistance is symmetric about a direction of the element current by using the power measurement device, and extracting a DC component of an output generated by supply of the element current as electric power information.

According to this configuration, there is no need to measure the power factor, separately, the measurement can be simplified, and as compared with a case using integration, an error can be also reduced.

Also, the magnetic field sensor may include a magnetic thin film, a feeder having an input and output terminal that supplies element current to the magnetic thin film, and a detector that detects a voltage across the magnetic thin film (between ends thereof) in a direction perpendicular to a direction of the element current, in which the magnetic thin film is formed so that the magnetic resistance is symmetric about the direction of the element current.

According to this configuration, the output extraction direction of the magnetic thin film is perpendicular to the element current direction, and the magnetic resistance is symmetric about the direction of the element current. As a result, because the positive and negative of the direction can be determined, and the offset when no magnetic field is applied is eliminated, the circuit configuration can be simplified.

Also, in the magnetic field measurement method in the power measurement device according to the present invention, the element current is supplied to the pattern of the magnetic thin film so that the magnetic resistance is symmetric about the direction of the element current, and the voltage across the magnetic thin film (between ends thereof) is detected in the direction perpendicular to the supply direction of the element current to measure the magnetic field intensity.

According to this configuration, the output extraction direction of the magnetic thin film is perpendicular to the element current direction, and the magnetic resistance is symmetric about the direction of the element current. As a result, because the positive and negative of the direction can be determined, and the offset when no magnetic field is applied is eliminated, the circuit configuration can be simplified.

The present invention is based on Japanese Patent Application Nos. 2009-195103 and 2009-195104 filed on August 26, 2009, and content thereof is incorporated herein by reference.

## Industrial Applicability

As has been described above, according to the magnetic field sensor of the present invention, since the magnetic field sensor can be detected with high precision, the magnetic field sensor can be applied to a current sensor or an electric power sensor.

Also, according to the power measurement device of the present invention, the accurate power measurement can be conducted even in a load where the power factor is not 1, or a harmonic current is included, and as compared with the conventional power measurement device using a current sensor such as a rectifier, the downsizing and the low costs can be performed. Therefore, the power measurement device according to the present invention is applicable to various power saving tools.

## Description of Reference Signs

1:          Substrate
2:          Insulating Film
3, 33:      Ferromagnetic Thin Film ((Loop) Pattern)
4, 24:      Auxiliary Pattern
5A,5B:      Feeder
5C, 5D:     Detector
100:        Ferromagnetic Thin Film
200:        Conductor

**Claims**

1. A magnetic field sensor comprising:

   a magnetic thin film;
   a feeder comprising an input and output terminals configured to supply element current to the magnetic thin film; and
   a detector configured to detect a voltage between ends of the magnetic thin film in a direction perpendicular to a direction of the element current,
   wherein the magnetic thin film is formed symmetric about the direction of the element current.

2. The magnetic field sensor according to claim 1,
   wherein the magnetic thin film has a circular contour.

3. The magnetic field sensor according to claim 1 or 2,
   wherein the magnetic thin film is formed of a loop body.

4. The magnetic field sensor according to claim 3,
   wherein the magnetic thin film is formed of a square loop body, and wherein the feeder allows the current to flow in a diagonal direction of the square.

5. The magnetic field sensor according to Claim 3,
   wherein the magnetic thin film has a uniform line width.

6. The magnetic field sensor according to any one of claims 2 to 5,
   wherein the magnetic thin film comprises an internal magnetic thin film provided in the loop body and made of a magnetic film.

7. The magnetic field sensor according to claim 6,
   wherein the internal magnetic thin film comprises a magnetic thin film made of the same material as that of the magnetic thin film.

8. The magnetic field sensor according to claim 6,
   wherein the internal magnetic thin film comprises a magnetic thin film different from the magnetic thin film.

9. A magnetic field measurement method comprising:

   supplying element current such that a pattern of a magnetic thin film is symmetric about a direction of the element current; and
   detecting a voltage between ends of the magnetic thin film in a direction perpendicular to a direction of supplying the element current, thereby measuring a magnetic field intensity.

10. A power measurement device, comprising:

   a magnetic field sensor comprising:

      a magnetic thin film arranged in parallel to a primary conductor in which AC current flows;
      a feeder connected to the primary conductor, and comprising input and output terminals configured to supply element current to the magnetic thin film through a resistor; and
a detector configured to detect outputs from ends of the magnetic thin film; and

a DC component extractor configured to extract a DC component from an output of the detector.

11. The power measurement device according to claim 10,
wherein the magnetic field sensor is formed on the same substrate as that of the DC component extractor.

12. The power measurement device according to claim 11,
wherein the magnetic thin film of the magnetic field sensor is formed on the substrate, and
wherein the detector is connected directly to a wiring pattern on the substrate.

13. The power measurement device according to claim 11,
wherein the magnetic field sensor comprises:

the magnetic thin film formed on the substrate;
the feeder comprising the input and output terminals configured to supply the element current to the magnetic thin film; and
a detection electrode configured to detect the outputs from the ends of the magnetic thin film,

wherein the wiring pattern is formed by the same conductor layer as that of the feeder and the detection electrode.

14. The power measurement device according to claim 13,
wherein the magnetic thin film is formed such that a magnetic resistor is symmetric about a direction of the element current.

15. The power measurement device according to any one of claims 10 to 14,
wherein the magnetic thin film has a magnetization direction identical with a direction of the element current.

16. The power measurement device according to any one of claims 10 to 15,
wherein the detector is formed in a direction perpendicular to a direction of the element current.

17. The power measurement device according to any one of claims 10 to 16,
wherein the DC component extractor comprises an integrator configured to integrate an output value every 1/f periods when a commercial frequency is f.

18. The power measurement device according to any one of claims 10 to 16, comprising:

a zero-cross point detector configured to detect a zero-cross point of a primary voltage of the element current,
wherein a drive timing of the DC component extractor is determined according to an output of the zero-cross point detector.

19. The power measurement device according to claim 18, comprising:

a capacitor connected in parallel to the detector.

20. A power measurement method using the power measurement device according to any one of claims 10 to 19, comprising:

supplying element current to a pattern of a magnetic thin film such that a magnetic resistance is symmetric about a direction of the element current; and
extracting a DC component of an output generated by supply of the element current, thereby taking the extracted DC component as electric power information.

*FIG. 1*

$V_{CD} = I_2 \Delta R \sin 2\theta$

3

200

C

A B

D

CURRENT DENSITY
VECTOR I

ELEMENT CURRENT $I_2$

*FIG. 2*

$V_{CD} = I_2 \Delta R \sin 2\theta$

ELEMENT CURRENT $I_2$

3

C

200

A

B

D

CURRENT DENSITY
VECTOR I

FIG. 3

FIG. 4

## FIG. 5

500

STABILIZING
POWER SUPPLY 503

502

IN−

±15V

501   C IN+

OUTPUT

OSCILLOSCOPE
6030A 504

TRIG

A     B

H

I₂  D

505               506

I₁

10KΩ            TRANS

507

## FIG. 6

$I_1 = 8.482\,A$       MIXED OUTPUT OF 60Hz, 120Hz, AND DC COMPONENT

max

mcan | pkpk

min

## FIG. 7

$I_1 = 0\,A$       MIXED OUTPUT OF 60Hz AND DC COMPONENT

FIG. 8

AVERAGE VALUE OF
ELEMENT OUTPUT
VOLTAGE Vmr (V)

$I_1$ (CURRENT VALUE (A))

# FIG. 9

$V_{CD} = I_2 \Delta R \sin 2\theta$

CURRENT DENSITY
VECTOR I

ELEMENT CURRENT $I_2$

FIG. 10

FIG. 11

FIG. 12

*FIG. 13*

3

24

*FIG. 14*

C

33

φ

$\theta_1$

Vmr

$\theta_2$

A

B

D

SPONTANEOUS MAGNETIZATION
M

EXTERNAL MAGNETIC FIELD
H

MAGNETIC FLUX DENSITY VECTOR $B_{MO}$

FIG. 15

5C

C

5A

5B

33

5D

FIG. 16

PRIMARY CONDUCTOR CURRENT I₁

10

PRIMARY
VOLTAGE V1
(AC 100 V)

3

CURRENT BY
PRIMARY VOLTAGE

7

## FIG. 17

EP 2 461 174 A1

## FIG. 18

## FIG. 19

## FIG. 20

# FIG. 21

(a)

(b)

(c)

(d)

H: PRIMARY
CONDUCTOR
POSITIVE
MAGNETIC
FIELD

H: PRIMARY
CONDUCTOR
NEGATIVE
MAGNETIC
FIELD

$B_{MO}$ : COMBINED MAGNETIC
FIELD INTENSITY (A/m)

## FIG. 22

ELEMENT OUTPUT VOLTAGE (V)

EXTERNAL MAGNETIC FIELD INTENSITY H (A/m)

## FIG. 23

$V_1$
100V
8

OUTPUT EXTRACTION POINT

POWER MEASUREMENT DEVICE

9

$I_1$

1A

$I_2$

$V_{mr}$

PRIMARY CONDUCTOR POSITIVE MAGNETIC FIELD

OUTPUT EXTRACTION POINT

10

EP 2 461 174 A1

## FIG. 24

(a)

$\Theta=0$ (MAGNETIC FIELD H IS ZERO)

ELEMENT
CURRENT $I_2$

R          R

Vmr=0

R          R

V

ONLY SPONTANEOUS MAGNETIZATION

(b)

$\Theta=\pi/4$

R          R

ELEMENT
CURRENT $I_2$

VOLTAGE
GENERATION
Vmr

R          R

$\Theta=\pi/4$

BMO:COMBINED MAGNETIC
FIELD DENSITY VECTOR

$\Theta=\pi/4$
EXTERNAL
MAGNETIC
FIELD

MAXIMUM VOLTAGE GENERATION WHEN $\Theta=\pi/4$

FIG. 25

## FIG. 26

EP 2 461 174 A1

*FIG. 27*

POWER MEASUREMENT DEVICE

PRIMARY CONDUCTOR CURRENT $I_1$

ZERO-CROSS POINT DETECTOR — 60

CYCLE DETERMINATION UNIT — 70

AMPLI-FIER — 20

A/D — 30

CPU — 40

POWER 100 W

EP 2 461 174 A1

# FIG. 28

$$V_{AB} = I_2(R + \Delta R \cos\theta)$$

3: FERROMAGNETIC
THIN FILM

ELEMENT CURRENT $I_1$

A                    B

ELEMENT CURRENT $I_2$

CURRENT DENSITY
VECTOR I

SPONTANEOUS MAGNETIZATION
M

MAGNETIC FIELD H

MAGNETIC FLUX DENSITY VECTOR $B_{MO}$

| | INTERNATIONAL SEARCH REPORT | International application No. |
|---|---|---|
| | | PCT/JP2010/064532 |

A. CLASSIFICATION OF SUBJECT MATTER
*G01R33/09*(2006.01)i, *G01R21/08*(2006.01)i, *H01L43/08*(2006.01)i

According to International Patent Classification (IPC) or to both national classification and IPC

B. FIELDS SEARCHED

Minimum documentation searched (classification system followed by classification symbols)
G01R33/02-10, G01R21/08-09, H01L43/00-14

Documentation searched other than minimum documentation to the extent that such documents are included in the fields searched
Jitsuyo Shinan Koho          1922-1996     Jitsuyo Shinan Toroku Koho    1996-2010
Kokai Jitsuyo Shinan Koho     1971-2010     Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 7-249808 A  (Jeco Co., Ltd.),<br>26 September 1995 (26.09.1995),<br>paragraphs [0010] to [0012], [0015]; fig. 1<br>(Family: none) | 1-5,9<br>10-20<br>6-8 |
| Y | JP 2-120677 A  (Fujitsu Ltd.),<br>08 May 1990 (08.05.1990),<br>page 2, lower right column, line 13 to page 3,<br>lower left column, line 17; fig. 2 to 3<br>(Family: none) | 10-20 |
| Y | JP 2000-035342 A  (Mitsubishi Electric Corp.),<br>02 February 2000 (02.02.2000),<br>paragraphs [0037] to [0045]; fig. 1 to 10, 44<br>& JP 2004-80056 A          & US 6661221 B2<br>& US 6426620 B1            & US 6239595 B1<br>& DE 19922136 A            & DE 19854713 A1 | 10-20 |

☒  Further documents are listed in the continuation of Box C.        ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 November, 2010 (10.11.10) | 22 November, 2010 (22.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| | International application No. |
|---|---|
| | PCT/JP2010/064532 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2004-279321 A  (Sanyo Electric Co., Ltd.), 07 October 2004 (07.10.2004), paragraphs [0054] to [0074] (Family: none) | 17-20 |
| A | JP 2008-003072 A  (Alps Electric Co., Ltd.), 10 January 2008 (10.01.2008), entire text; all drawings (Family: none) | 6-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11274598 A
- JP 2009195103 A
- JP 2009195104 A

**Non-patent literature cited in the description**

- Thin Film Power Meter using Magnetic Film. Magnetic Association, vol. MAG-05
- Thin Film Power Meter using Magnetic Film. Magnetic Association Document, vol. MAG-05